Europäisches Patentamt

European Patent Office

Office européen des brevets

(11) Publication number: **0 309 748**
**A1**

# EUROPEAN PATENT APPLICATION

(21) Application number: **88114064.4**

(22) Date of filing: **29.08.88**

(51) Int. Cl.4: **H01L 29/78** , //**H01L27/08,**
**H01L27/06**

(30) Priority: **28.09.87 DE 3732613**

(43) Date of publication of application:
**05.04.89 Bulletin 89/14**

(84) Designated Contracting States:
**DE FR GB IT**

(71) Applicant: **Siemens Aktiengesellschaft Berlin
und München**
**Wittelsbacherplatz 2**
**D-8000 München 2(DE)**

(72) Inventor: **Hargasser, Hans, Dipl.-Ing. FH**
**Salzmannstrasse 46**
**D-8000 München 83(DE)**
Inventor: **Höltge, Harald, Dipl.-Ing.**
**Auenstrasse 100a**
**D-8000 München 5(DE)**

(54) **Low feedback MOS triode.**

(57) Eine MOS-Triode soll höhere Einsatzfrequenzen, eine größere Vorwärtssteilheit und eine geringere Streubreite des Drainstromes als bekannte Trioden aufweisen. Die MOS-Triode besitzt ein zweites Gate (G2), mit einem zweiten Kanal unter dem zweiten Gate (G2), der so dotiert ist, daß er schon ohne positive Vorspannung eine ausreichende Leitfähigkeit besitzt. Zwischen Source (S) und dem zweiten Gate (G2) und dem Substrat ist eine niederohmige Leitung vorhanden.

EP 0 309 748 A1

## Rückwirkungsarme MOS-Triode

Die Erfindung betrifft eine MOS-Triode nach dem Oberbegriff des Anspruchs 1.

Überwiegend kapazitive Rückwirkung zwischen Ausgang und Eingang eines aktiven Bauelementes kann insbesondere bei hohen Frequenzen den Einsatz als Verstärkerelement stören oder wegen Störschwingungen unmöglich machen. Trioden weisen üblicherweise eine wesentlich größere kapazitive Rückwirkung auf als Tetroden oder Pentoden. Das technische Problem ist die Reduzierung der Rückwirkung von Drain auf das Gate einer MOS-Triode.

Bisher wurden z. B. anstelle von Trioden rückwirkungsarme Tetroden eingesetzt. Tetroden erfordern jedoch im Vergleich zu Trioden einen zusätzlichen Anschluß auf dem Chip für das zweite, im Vergleich zu Trioden zusätzliche Gate, und eine Herausführung am Gehäuse der Tetrode für diesen zusätzlichen Anschluß, der auf Grund des 2. Gates bei einer Tetrode erforderlich ist, sowie auf der Platine eines Verstärkers einen Abblock-Kondensator und einen Widerstand zum Spannungsanschluß.

Eine weitere bekannte Möglichkeit besteht in der Anwendung eines Junction-Feldeffekt-Transistors, z. B. von NEC mit der Typenbezeichnung 2SK193. Dieser Junction-Feldeffekt-Transistor weist als Besonderheit ein 2., zusätzliches Gate neben der nach außen aus dem Gehäuse herausgeführten Steuerelektrode, die zum 1. Gate gehört, auf. Bei diesem bekannten Junction-Feldeffekt-Transistors wird das 2., zusätzliche Gate jedoch nicht nach außen geführt. Der Kanal unter dem 2., zusätzlichen Gate ist durch eine spezielle Dotierung leitend gemacht und dient der Reduzierung der Rückwirkung infolge einer Reduzierung von Felddurchgriff und von kapazitiver Rückwirkung von Drain auf das 1. Gate dieses bekannten Junction-Feldeffekt-Transistors.

Der vorliegenden Erfindung liegt die Aufgabe zugrunde, eine MOS-Triode der eingangs genannten Art anzugeben, die höhere Einsatzfrequenzen, eine größere Vorwärtssteilheit und eine geringere Streubreite des Drainstromes als bekannte Trioden aufweist.

Diese Aufgabe wird erfindungsgemäß durch eine MOS-Triode nach dem Anspruch gelöst.

Ein Verstärker-Element nach dem Anspruch weist die vergleichbare Rückwirkung einer Tetrode auf und benötigt nur 3 Anschlüsse.

Im Vergleich zu einem bekannten Junction-Feldeffekt-Transistor weist eine MOS-Tridode nach der Erfindung folgende Vorteile auf:

Die MOS-Technologie erlaubt eine um den Faktor 10 höhere Einsatzfrequenz;

Die Vorwärtssteilheit kann bis zu einem Faktor 5....10 höher liegen;

Die für die Anwendung wichtige Streubreite des Drainstromes $I_{DSS}$ (Gate 1 an Source), welche durch Streuungen der Kanaldotierung bei der Herstellung großer Stückzahlen von Bauelementen bedingt ist, beträgt nur etwa 30 %.

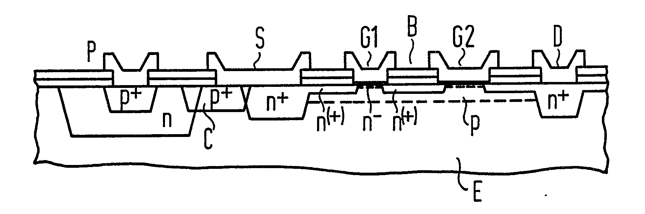

Die Erfindung wird anhand der Zeichnung näher erläutert.

Die FIG. zeigt schematisch einen Querschnitt durch eine MOS-Triode.

Die Skizze des Querschnitts einer MOS-Triode in der FIG. zeigt, daß der Aufbau der MOS-Triode ähnlich ist dem Aufbau einer MOS-Tetrode.

Auf einem z. B. p-leitenden Substrat befindet sich eine $p^-$-leitende epitaktische Schicht E, in der $n^+$-leitende Zonen für Source S und Drain D sowie für einen Bereich B zwischen dem 1. Gate G1 und dem 2. Gate G2 vorgesehen sind. Die $n^+$-leitende Zone im Bereich B zwischen dem 1. Gate G1 und dem 2. Gate G2 dient bei einer Tetrode als Drain im Hinblick auf das 1. Gate G1 und gleichzeitig als Sourche im Hinblick auf das 2. Gate G2. Im Bereich der Source S, des 1. Gates G1, des 2. Gates G2 und dem Drain-Bereich sind jeweils Metallisierungen als Elektrodenanschlüsse vorgesehen. Die n-dotierten Zonen von Source S, Drain D und im Bereich B müssen in Nähe der Kanäle der Gates G1, G2 nicht unbedingt hoch dotiert sein. Unterhalb der Gateelektroden von Gate G1 und Gate G2 befinden sich jeweils $n^-$-dotierte Kanäle. Am linken Rand der FIG. befindet sich eine Schutzdiode P. Zwischen der Schutzdiode P und dem Source-Bereich befindet sich ein $p^+$-dotierter Bereich als Channel-Stopper.

Die rückwirkungsarme Triode unterscheidet sich von einer MOS-Tetrode in folgenden Punkten:

Der Kanal unter dem 2. Gate G2 ist durch eine speziell gewählte Dotierung in seiner Leitfähigkeit so eingestellt, daß schon ohne positive Vorspannung (Beispiel: N-channel normally on-transistor) eine ausreichende Leitfähigkeit erreicht ist, z. B. auch bei einer Spannung $U_{G2S}$ zwischen dem 2. Gate G2 und Source von 0 Volt. Dies bedeutet, daß der Kanal unter dem 2. Gate G2 auch dann bereits in einem für den Betrieb der MOS-Triode ausreichendem Maße leitet, wenn zwischen dem 2. Gate G2 und der Source-Elektrode keine Spannung anliegt;

Der Source-Bereich und der Bereich des 2. Gates G2 werden mit dem Substrat über eine niederohmige Leitung verbunden.

## Claims

MOS-Triode, **gekennzeichnet durch** ein 2. Gate (G2), mit einem 2. Kanal unter dem 2. Gate (G2), der so dotiert ist, daß er schon ohne positive Vorspannung eine ausreichende Leitfähigkeit besitzt,
und durch eine niederohmige Leitung zwischen Source (S) und dem 2. Gate (G2) und dem Substrat.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | DE-A-3 024 296 (TOKYO SHIBAURA DENKI K.K.) <br> * Seite 6, Zeile 29 - Seite 8, Zeile 31; Figuren 4,5,7,8 * <br> --- | 1 | H 01 L 29/78 // <br> H 01 L 27/08 <br> H 01 L 27/06 |
| X | US-A-3 872 491 (HANSON et al.) <br> * Spalte 3, Zeile 40 - Spalte 4, Zeile 20; Spalte 4, Zeile 36 - Spalte 5, Zeile 11; Figuren 2,6 * <br> --- | 1 | |
| X | DE-A-2 855 844 (TEXAS INSTRUMENTS DEUTSCHLAND GmbH) <br> * Seite 8, Zeile 23 - Seite 9, Zeile 16; Figur 4 * <br> ----- | 1 | |
| | | | **RECHERCHIERTE SACHGEBIETE (Int. Cl.4)** |
| | | | H 01 L |

Der vorliegende Recherchenbericht wurde für alle Patentansprüche erstellt

| Recherchenort | Abschlußdatum der Recherche | Prüfer |
|---|---|---|
| DEN HAAG | 07-12-1988 | MORVAN D.L.D. |